# FASCICULE DE BREVET EUROPEEN

(11) **EP 2 365 513 B1**
(45) Date de publication et mention de la délivrance du brevet: **30.10.2013**
(21) Numéro de dépôt: 11305252.6
(22) Date de dépôt: 09.03.2011
(51) Int. Cl.: H01J 37/08, H01J 37/09, H01J 37/305

(54) **Enveloppe de protection pour canon à ions, dispositif de dépôt de matériaux par évaporation sous vide comprenant une telle enveloppe de protection et procédé de dépôt de matériaux**
Schutzumhüllung für eine Ionenkanone, Gerät zur Materialabscheidung durch Vakuumverdampfung mit einer solchen Schutzumhüllung und Verfahren zur Materialabscheidung
Protective envelope for an ion beam gun, vacuum deposition device using evaporation and including such a protective envelope and material deposition process

(30) Priorité: 09.03.2010 FR 1051703
(43) Date de publication de la demande: 14.09.2011
(73) Titulaire: ESSILOR INTERNATIONAL (Compagnie Générale d'Optique), 94220 Charenton le Pont (FR)
(72) Inventeur: Conte, Dominique, 94220 Charenton Le Pont (FR); Sirjean, Jean-Louis, 94220 Charenton Le Pont (FR)
(74) Mandataire: Catherine, Alain

(56) Documents cités:
- EP-A2- 1 160 351
- WO-A1-97/30467
- WO-A2-2004/023508
- CH-A- 318 624
- DE-A1- 19 833 718
- JP-A- 7 224 381
- US-A- 4 761 199
- US-A- 5 878 074
- US-A- 5 883 393
- US-A1- 2004 051 465
- US-A1- 2005 238 801
- US-A1- 2008 073 579
- US-A1- 2008 264 340
- Tamulevicius: "Stress and strain in the vacuum deposited thin films", Vacuum, vol. 51, no. 2, 1 October 1998 (1998-10-01), pages 127-139, XP055049850,

## Description

L'invention concerne un dispositif de dépôt de matériaux par évaporation sous vide comprenant une enveloppe de protection pour canon à ions et un procédé de dépôt de matériaux.

L'invention est plus particulièrement destinée au domaine du traitement de surface sur des lentilles ophtalmiques, en particulier pour des lunettes.

Quelle que soit la nature minérale, organique ou composite, de leur matière constitutive, il est connu qu'il est souvent nécessaire d'appliquer aux lentilles ophtalmiques, après fabrication, un traitement de surface de nature à en renforcer certaines caractéristiques ou de nature à leur conférer des caractéristiques particulières.

Il peut s'agir, par exemple, d'un traitement antireflet et/ou d'un traitement de durcissement.

La présente invention vise plus particulièrement, encore, le cas où la réalisation d'un tel traitement se fait par dépôt d'un revêtement formé d'au moins une couche de matériau, et où, pour un tel dépôt, il est procédé par évaporation, et, plus précisément, par évaporation sous vide.

Le plus souvent, le revêtement est un revêtement multicouche, c'est-à-dire un revêtement impliquant l'empilement de plusieurs couches les unes sur les autres.

Les diverses couches ainsi mises en oeuvre peuvent être constituées de matériaux différents, de matériaux identiques déposés sous des épaisseurs différentes, ou, encore, de matériaux identiques déposés sous des épaisseurs identiques. Dans ce dernier cas, les couches sont déposées avec des paramètres d'évaporation différents, de sorte que leurs propriétés physico-chimiques sont différentes.

Par exemple, pour un traitement antireflet, il est ainsi couramment procédé à un empilement multicouche comprenant une alternance de couches de bas indice et de haut indice de réfraction et une couche hydrophobe.

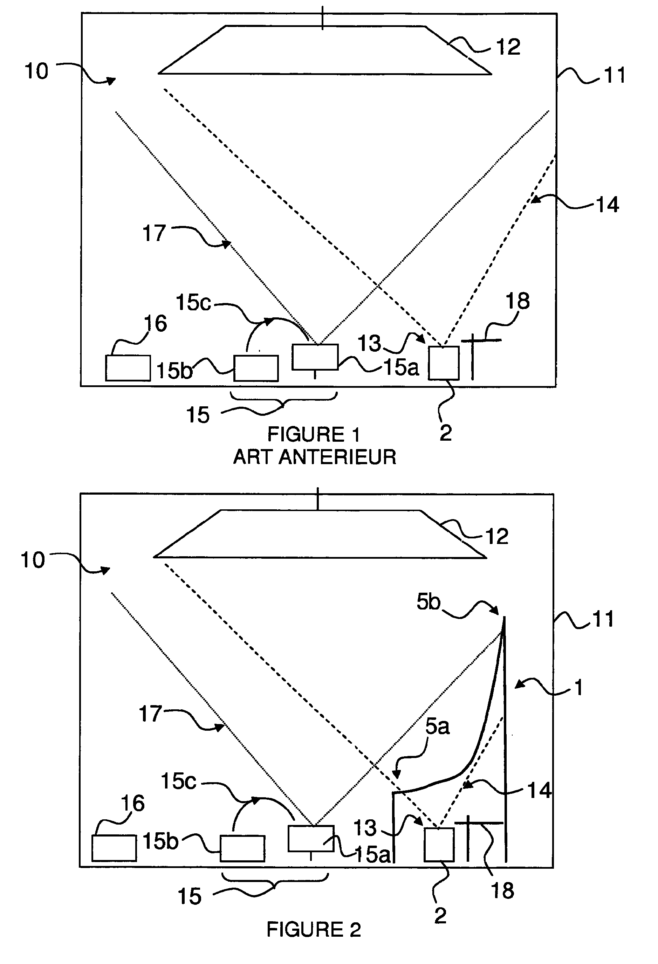

Un tel traitement antireflet est réalisé dans un dispositif de dépôt de matériaux par évaporation sous vide, tel qu'illustré sur la figure 1 représentant un dispositif de dépôt de matériaux connu.

Le dispositif de dépôt de matériaux par évaporation sous vide comprend une enceinte de traitement 10 délimitée par des parois latérales 11, un porte-substrats 12, un canon à ions 2 comprenant une sortie 13 apte à générer un faisceau d'ions 14 dirigé vers le porte-substrats 12, une source de matériaux 15a (typiquement oxydes métalliques et/ou silice) évaporables par bombardement avec un faisceau d'électrons 15c, un canon à électrons 15b apte à bombarder d'électrons ladite source de matériaux 15a pour générer un faisceau de matériaux évaporés 17 dirigé vers le porte-substrats 12, un cache canon 18 mobile en rotation entre une position d'obturation a), et une position de dégagement b) de la sortie du canon à ions 2, et une source de matériaux 16 évaporables par effet Joule (typiquement matériau hydrophobe),

Des caches mobiles (non représentés sur la figure 1) sont positionnés au dessus des sources de matériaux 15a et 16.

Les caches recouvrent les sources tant que la température souhaitée pour l'évaporation du matériau à évaporer n'est pas atteinte. Lorsque celle-ci est atteinte, les caches sont dégagés et le dépôt des matériaux peut débuter.

Le plus souvent, un grand nombre de substrats sont traités en même temps. Le porte-substrats, qui est en forme de calotte sphérique, est monté rotatif, et présente une pluralité d'emplacements propres à recevoir chacun un substrat à traiter. Les emplacements sont répartis autour de l'axe de rotation du porte-substrats.

Généralement, la source de matériaux 15a est constituée par un support sur lequel est disposé le matériau à évaporer, par exemple un creuset ou une platine. L'évaporation du matériau est le plus souvent provoquée par un bombardement électronique généré par le canon à électrons 15b.

Le traitement avec un canon à ions a pour but, soit de préparer la surface du substrat avant dépôt d'une couche (traitement appelé IPC « Ion Pre Cleaning »), soit lors du dépôt d'une couche, de la densifier (procédé IAD « Ion Aided Deposition »), de l'oxyder, ou de la rendre transparente.

Néanmoins, le dépôt de matériaux à partir d'une source de matériaux et le traitement avec un canon à ions entraînent des problèmes de salissures à la fois sur les parois de l'enceinte de traitement et sur le canon à ions.

En effet, le faisceau de matériaux évaporés à partir de la source d'évaporation 15a se présente sous la forme d'un cône large, salissant, à la fois les parois de l'enceinte de traitement et le canon à ions.

Il est connu qu'il est possible de contrôler l'angle ou la largeur du cône d'évaporation en modifiant le débit de matériaux évaporé. Il est possible de faire varier la taille du creuset et/ou la puissance du canon à électrons, par exemple.

Néanmoins, ce contrôle est difficilement réalisable dans la pratique car la modification de ces paramètres, qui sont calibrés pour obtenir une qualité de dépôt souhaité, peut influer de façon négative sur la qualité du dépôt.

Il est donc pratiquement impossible de diriger le faisceau de matériaux évaporés ou le cône d'évaporation uniquement vers le porte-échantillons, afin d'éviter de polluer les parois latérales de l'enceinte de traitement et le canon à ions.

De la même façon, l'évaporation de matériaux issus de la source de matériaux par effet Joule 16 entraîne également une pollution des parois de l'enceinte à vide et du canon à ions.

Un autre problème est lié à l'apparition, au cours de l'utilisation du canon à ions, de salissures qui se forment essentiellement à l'intérieur du canon à ions.

Les causes de ces salissures sont extrêmement diverses. Lors du fonctionnement normal du canon à ions, il se produit un phénomène parasite de pulvérisation cathodique omnidirectionnelle de tungstène (matériau constituant la cathode), ainsi qu'une pulvérisation cathodique du matériau constituant le diffuseur (distributeur de gaz, typiquement inox, titane, carbone, tungstène, ou tantale ...) et/ou de l'anode du canon à ions.

Il se produit également un phénomène d'oxydation lorsque l'entrée d'air est faite en fin de dépôt des couches car le canon est très chaud.

Ces salissures se déposent sur le canon à ions. Elles sont préjudiciables à un bon fonctionnement de celui-ci et à un régime stable de dépôt.

Les pièces les plus salies du canon à ions sont le couvercle, les supports anode supérieur et inférieur, le diffuseur (distributeur de gaz en titane), l'anode et, dans une moindre mesure les vis de fixation de ces pièces.

Avant l'émission du faisceau d'ions sur les substrats, le canon à ions subit une étape d'amorçage, pendant laquelle un cache en acier inoxydable est positionné au dessus du canon à ions. Au cours de cette étape, des ions émis par le canon à ions frappent la surface inférieure du cache et peuvent provoquer une pulvérisation d'inox.

Les salissures, émises par le canon à ions, se déposent sur les accessoires, la fausse platine et les parois latérales de l'enceinte de traitement, et s'ajoutent aux salissures émises par les sources d'évaporation. D'autre part, au cours du fonctionnement du canon à ions et lorsque le cache est ouvert, des ions sont émis sur les substrats (étapes IPC, IAD ...) mais également sur les parois latérales de l'enceinte de traitement, pouvant entraîner, dans certaines conditions :
- une pulvérisation non contrôlée des matériaux précédemment déposés sur ces parois latérales. Cette pulvérisation non contrôlée de matériaux pollue les substrats, les interfaces et les empilements.
- la réflexion d'ions sur les substrats, d'énergie plus faible et non contrôlable.

Les salissures générées à la fois par le canon à ions et les sources d'évaporation de matériaux sur les parois latérales de l'enceinte de traitement et le canon à ions impliquent la nécessité de procéder à un démontage et un nettoyage régulier de ces derniers.

Ce nettoyage comprend une opération de sablage des parois de l'enceinte de traitement et des éléments constituant le canon à ions. Typiquement, cette opération de nettoyage est réalisée environ tous les 32 cycles d'évaporations au maximum, voire plus fréquemment pour des procédés avec des étapes IAD, et entraîne l'arrêt total du dispositif de dépôt de matériaux.

De plus, une fois que le canon à ions et les parois de l'enceinte de traitement sont remontés, il est nécessaire, pour que le dispositif de dépôt soit opérationnel, de réaliser un dégazage d'au moins 30 min pour désorber les gaz accumulés sur les parois latérales de l'enceinte de traitement qui présentent de grandes surfaces.

Ces opérations de nettoyage entraînent des temps de maintenance longs et coûteux, pendant lesquels le dispositif de dépôt est inutilisable.

L'invention a pour but de proposer un moyen permettant de limiter ces temps de maintenance. L'invention atteint le but précité en fournissant une enveloppe de protection pour canon à ions destinée à un dispositif de dépôt de matériaux par évaporation sous vide permettant de limiter la formation de salissures sur une grande partie des parois latérales de l'enceinte de traitement et sur le canon à ions.

L'invention permet de réaliser un plus grand nombre de cycles d'évaporation de matériaux entre deux opérations de nettoyage des parois latérales de l'enceinte de traitement.

Selon l'invention, l'enveloppe de protection comprend une paroi latérale destinée à entourer ledit canon à ions, et une extrémité supérieure ouverte, ladite enveloppe de protection présentant un axe longitudinal, une forme de tube tronqué à son extrémité supérieure ouverte par une surface inclinée par rapport audit axe longitudinal, et comprenant une partie basse et une partie haute.

Dans différents modes de réalisation possibles, la présente invention concerne également les caractéristiques suivantes qui pourront être considérées isolément ou selon toutes leurs combinaisons techniquement possibles et apportent chacune des avantages spécifiques :
- l'enveloppe de protection présente une forme de tube tronqué à son extrémité supérieure ouverte par une surface inclinée et incurvée dans une direction opposée à ladite extrémité supérieure ouverte,
- l'extrémité supérieure ouverte de l'enveloppe de protection présente une section inférieure sensiblement parallèle à un plan perpendiculaire à l'axe longitudinal de l'enveloppe de protection, et une section supérieure inclinée par rapport à ladite section inférieure, lesdites sections se rejoignant en formant un angle,
- l'enveloppe de protection comprend une base munie d'un orifice apte à être traversé par le canon à ions.

Un premier objet de l'invention est un dispositif de dépôt de matériaux par évaporation sous vide comprenant une enceinte de traitement délimitée au moins par des parois latérales, ladite enceinte de traitement comportant un porte-substrats, un canon à ions positionné à proximité d'une des parois latérales de l'enceinte de traitement, et comprenant une sortie apte à générer un faisceau d'ions dirigé vers le porte-substrats, au moins une source d'évaporation de matériaux, et un cache canon mobile, de préférence en rotation, entre une position d'obturation a), et une position de dégagement b) de la sortie du canon à ions, ledit canon à ions (2) étant entouré par une enveloppe de protection (1) comprenant une paroi latérale (3) destinée à entourer ledit canon à ions (2), et une extrémité supérieure ouverte (4), ladite enveloppe de protection (1) présentant un axe longitudinal (20), une forme de tube tronqué à son extrémité supérieure ouverte (4) par une surface inclinée par rapport audit axe longitudinal (20), et comprenant une partie basse (5a) et une partie haute (5b), ladite enveloppe de protection (1) étant disposée de façon à ce que la partie haute (5b) de l'enveloppe de protection (1) soit positionnée le long d'une des parois latérales (11) de l'enceinte de traitement, et de façon à ce que l'extrémité supérieure ouverte (4) de l'enveloppe de protection (1) soit dirigée vers le porte-substrats (12, le cache-canon (18) étant positionné à l'intérieur de l'enveloppe de protection (1), la hauteur du cache-canon étant inférieure à celle de la partie basse de l'enveloppe de protection (1), la paroi latérale (3) de l'enveloppe de protection (1) comprenant une fente (19) allongée et configurée de façon à être traversée par le cache-canon (18) lorsqu'il se déplace entre les positions d'obturation a) et de dégagement b) de la sortie du canon à ions, ledit cache-canon étant mobile dans un plan sensiblement perpendiculaire à l'axe longitudinal (20) de l'enveloppe de protection

L'axe du canon à ions peut être parallèle à l'axe de rotation du porte-substrats, ou bien l'axe du canon à ion et du porte-substrats peuvent former entre eux un angle aigu, typiquement de 10° à 30°, mieux de 20° à 30°.

Selon l'invention, ledit canon à ions est entouré par une enveloppe de protection telle que définie précédemment, ladite enveloppe de protection étant orientée de façon à ce que la partie haute de l'enveloppe de protection soit positionnée le long d'une des parois latérales de l'enceinte de traitement, et de façon à ce que l'extrémité supérieure ouverte de l'enveloppe de protection soit dirigée vers le porte-substrats.

Dans différents modes de réalisation possibles, la présente invention concerne également les caractéristiques suivantes qui pourront être considérées isolément ou selon toutes leurs combinaisons techniquement possibles et apportent chacune des avantages spécifiques :
- la hauteur de la partie basse de l'enveloppe de protection est à la fois supérieure à la hauteur du canon à ions et adaptée pour que la partie basse de l'enveloppe de protection n'empêche pas le faisceau d'ions d'atteindre le porte-substrats,
- le dispositif de dépôt comprend un canon à électrons apte à bombarder d'électrons ladite source d'évaporation de matériaux pour générer un faisceau de matériaux évaporés dirigé vers le porte-substrats, la hauteur de la partie basse de l'enveloppe de protection étant adaptée pour que la partie basse de l'enveloppe de protection n'empêche ni le faisceau d'ions, ni le faisceau de matériaux évaporés d'atteindre le porte-substrats,
- le cache canon est au moins partiellement en dehors de l'enveloppe de protection lorsqu'il est en position de dégagement b) de la sortie du canon à ion,
- le cache canon est un disque plan ayant une dimension proche de celle du canon à ions, et au moins suffisante pour recouvrir la sortie du canon à ion,
- l'enveloppe de protection constitue un masque permettant de réduire l'angle solide du cône d'ions émis vers le porte-substrats et limitant l'émission d'ions vers les parois latérales de l'enceinte de traitement.

L'invention concerne également un procédé de dépôt de matériaux sur des substrats par évaporation sous vide.

Selon l'invention, les matériaux sont évaporés et déposés sur les substrats dans un dispositif de dépôt tel que défini précédemment.

Ainsi, l'invention fournit une enveloppe de protection pour canon à ions destinée à un dispositif de dépôt de matériaux par évaporation sous vide permettant de limiter la formation de salissures sur les parois latérales de l'enceinte de traitement et sur le canon à ions.

L'invention permet de protéger à la fois le canon à ions, le cache canon et une des parois latérales de l'enceinte de traitement de la pollution provenant du cône d'évaporation de matériaux.

L'invention permet également, lorsque le canon à ions fonctionne sous cache, de protéger le reste de l'enceinte de traitement de la pollution provenant du canon à ions, en contenant les polluants dans la partie basse de l'enveloppe de protection. Les salissures, émises par le canon à ions et par son cache sont confinées dans l'enveloppe de protection.

Pendant l'étape de traitement des substrats par le canon à ions, l'enveloppe de protection permet de jouer également un rôle de masque et de réduire ainsi l'angle solide du cône d'ions émis vers le porte-substrats. Moins d'ions sont émis sur les parois latérales de l'enceinte de traitement.

L'enveloppe de protection est facilement démontable. Elle peut être démontée tous les jours pour un nettoyage régulier. Son temps de sablage est rapide (1 min environ).

Il est ainsi possible de réaliser un plus grand nombre de cycles d'évaporations de matériaux entre deux opérations de nettoyage des parois latérales de l'enceinte de traitement.

De manière surprenante, l'invention permet de réaliser 96 cycles de procédés avec des étapes IAD longues entre deux opérations de nettoyage des parois latérales de l'enceinte de traitement, contre 32 cycles de procédé sans étape IAD, ou avec des étapes IAD courtes, avec un dispositif de dépôt de l'art antérieur, voire moins de 32 cycles dans le cas de procédés avec des étapes IAD longues. On effectue un simple nettoyage journalier de l'enveloppe de protection.

Le temps pendant lequel l'enceinte de traitement n'est pas utilisable est considérablement réduit.

De plus, en utilisant deux enveloppes de protection, il est possible d'effectuer l'opération de nettoyage en temps masqué.

L'invention concerne également un procédé de dépôt de matériaux par évaporation sous vide.

Selon l'invention, les matériaux sont déposés sur des substrats dans un dispositif de dépôt tel que défini précédemment.

L'invention sera décrite plus en détail, mais de façon non limitative, en référence aux dessins annexés dans lesquels :
- la figure 1 représente schématiquement un dispositif de dépôt de matériaux par évaporation sous vide de l'art antérieur ;
- la figure 2 représente schématiquement un dispositif de dépôt de matériaux par évaporation sous vide, selon un mode de réalisation de l'invention ;
- la figure 3 représente une vue à trois dimensions de ce dispositif de dépôt ;

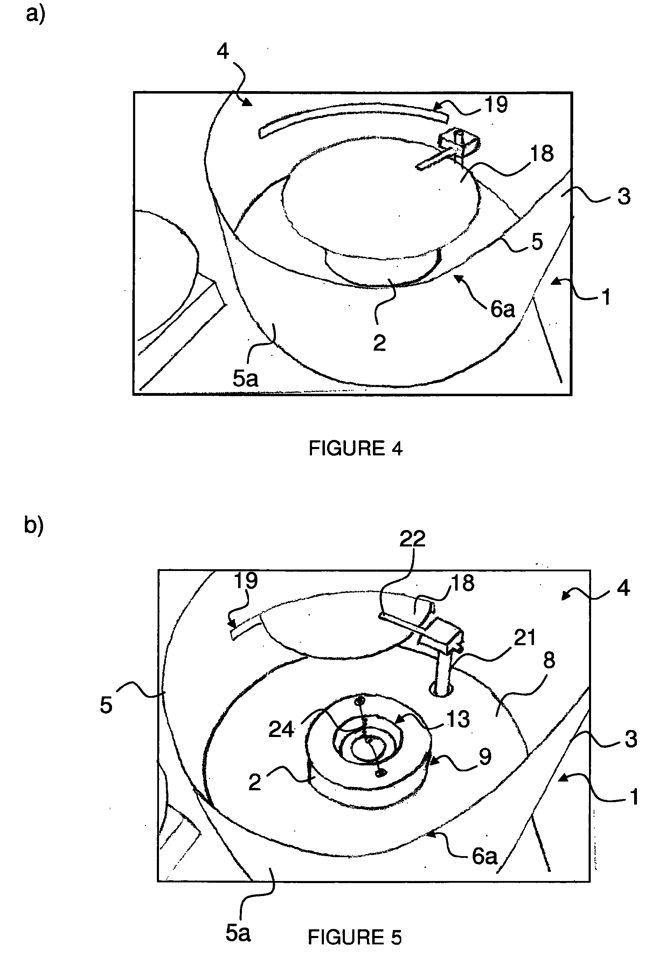

- la figure 4 représente le détail d'une enveloppe de protection pour canon à ions lorsque le cache canon est en position d'obturation a) ;
- la figure 5 représente le détail d'une enveloppe de protection pour canon à ions lorsque le cache canon est en position de dégagement b).

La figure 1 représente schématiquement un dispositif de dépôt de matériaux par évaporation sous vide de l'art antérieur.

Ce dispositif de dépôt de matériaux par évaporation sous vide comprend une enceinte de traitement 10 délimitée par des parois latérales 11, un porte-substrats 12, un canon à ions 2 positionné à proximité d'une des parois latérales 11 de l'enceinte de traitement, et comprenant une sortie 13 apte à générer un faisceau d'ions 14 dirigé vers le porte-substrats 12.

Le dispositif de dépôt de matériaux par évaporation sous vide comprend au moins une source d'évaporation de matériaux 15a, 16, qui peut être une source d'évaporation de matériaux par effet Joule 16 ou une source d'évaporation de matériaux 15a (creuset par exemple) destinée à être bombardée d'électrons par un canon à électrons 15b pour provoquer l'évaporation du matériau.

Dans cet exemple, le dispositif de dépôt de matériaux comprend une source d'évaporation de matériaux par effet Joule 16, une source d'évaporation de matériaux 15a destinée à être bombardée d'électrons, un canon à électrons 15b, et un cache canon à ions 18 mobile en rotation entre une position d'obturation a), et une position de dégagement b) de la sortie du canon à ions 2. Ces éléments sont encastrés dans un support 23 (ou fausse platine).

Le canon à électrons 15b est apte à bombarder d'électrons la source de matériaux 15a afin de générer un faisceau de matériaux évaporés 17 dirigé vers le porte-substrats 12.

Le faisceau de matériaux évaporés à partir de la source d'évaporation de matériaux par effet Joule 16 se présente sous la forme d'un cône d'évaporation (non représenté).

Dans la figure 1, la source d'évaporation de matériaux 15a et le canon à électrons 15b sont en position centrale dans l'enceinte de traitement, et la source d'évaporation de matériaux à effet joule 16 est en position périphérique. Alternativement, leurs positions respectives peuvent être inversées.

On peut également opérer selon le cas avec une seule de ces sources d'évaporation de matériaux 15a, 16.

Comme vu précédemment, un tel dispositif de dépôt entraîne des problèmes de salissures à la fois sur les parois de l'enceinte de traitement et sur le canon à ions, entraînant des temps de nettoyage longs et coûteux et surtout une pollution du canon à ions.

D'autres dispositifs sont décrits dans les demandes WO 2004/023508, US 2005/238801, US 5883393, WO 97/30467, US 2008/264340, US 5878074, US 4761199, US 2004/051465, US 20081073579, JP 7224381 et dans l'article Vacuum, vol. 51, N°2, 1er octobre 1998, 127-139.

Le dispositif de dépôt de matériaux par évaporation sous vide de la figure 2 représentant un mode de réalisation possible de l'invention, permet de résoudre ces problèmes.

Ce dispositif de dépôt de matériaux par évaporation sous vide comprend tous les éléments de la figure 1 cités précédemment.

Il comprend en plus une enveloppe de protection 1 pour canon à ions 2 comportant une paroi latérale 3 destinée à entourer le canon à ions 2, et une extrémité supérieure ouverte 4.

L'enveloppe de protection 1 présente un axe longitudinal 20, et une forme de tube tronqué à son extrémité supérieure ouverte 4 par une surface inclinée par rapport à l'axe longitudinal 20. L'enveloppe de protection 1 comporte un bord d'extrémité supérieure 5, une partie basse 5a, et une partie haute 5b. Cette surface inclinée peut présenter différentes formes. Elle peut être incurvée ou plane, par exemple. Le bord d'extrémité supérieure 5 délimite l'ouverture de l'enveloppe de protection 1 qui est orientée vers le porte-substrats.

Autrement dit, l'enveloppe de protection 1 présente une forme générale de biseau ou de mitre (forme de chapeau de pape).

Selon un mode de réalisation possible de l'invention, l'extrémité supérieure ouverte 4 de l'enveloppe de protection 1 présente une section inférieure 6a sensiblement parallèle à un plan perpendiculaire à l'axe longitudinal 20 de l'enveloppe de protection 1, et une section supérieure 6b inclinée par rapport à la section inférieure 6a. Les sections 6a, 6b se rejoignent en formant un angle 7.

Alternativement, la section inférieure 6a peut ne pas être parallèle au plan perpendiculaire à l'axe longitudinal 20 de l'enveloppe de protection 1 et peut être inclinée par rapport à ce plan.

Le plan perpendiculaire à l'axe longitudinal 20 de l'enveloppe de protection 1 est en fait confondu avec le plan horizontal lorsque l'enveloppe de protection 1 entoure le canon à ions.

L'enveloppe de protection 1 est préférentiellement cylindrique et est centrée par rapport au canon à ions.

L'enveloppe de protection 1 comprend une base 8 cylindrique munie d'un orifice 9 apte à être traversé par le canon à ions 2. L'enveloppe de protection 1 est rigide et en inox amagnétique.

Préférentiellement, le diamètre maximum de l'enveloppe de protection ne dépasse pas 3 fois le diamètre du canon à ions et représente typiquement de l'ordre de 2 fois le diamètre du canon à ions.

Lorsque le canon à ions 2 est entouré par l'enveloppe de protection 1, cette dernière est disposée de façon à ce que la partie haute 5b de l'enveloppe soit positionnée au voisinage ou le long d'une des parois latérales 11 de l'enceinte de traitement 10.

La fonction de cette partie haute 5b est de protéger une des parois latérales 11 contre les salissures provenant des sources d'évaporation de matériaux 15a, 16 et du canon à ions 2.

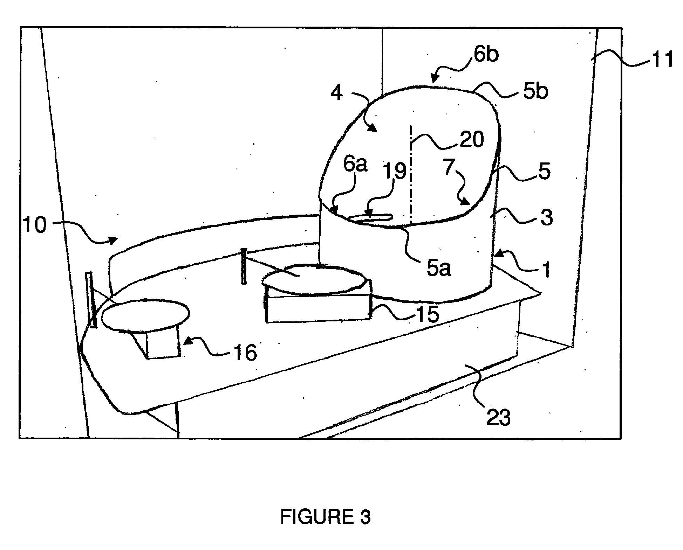

La partie basse 5a de l'enveloppe de protection 1 est positionnée sensiblement face à l'ensemble d'évaporation 15 constitué de la source de matériaux 15a et du canon à ions 15b (les éléments référencés 15a et 15b ne sont pas représentés sur la figure 3).

L'extrémité supérieure ouverte 4 de l'enveloppe de protection 1 est dirigée vers le porte-substrats 12.

La hauteur de la partie basse 5a de l'enveloppe de protection 1 est à la fois supérieure à la hauteur du canon à ions 2 et adaptée pour que la partie basse 5a de l'enveloppe ne coupe pas les faisceaux d'ions 14, et de matériaux évaporés 17 dirigés vers le porte-substrats.

La hauteur de la partie basse 5a de l'enveloppe ne doit pas être supérieure à une hauteur limite pour laquelle les faisceaux d'ions 14, et de matériaux évaporés 17 dirigés vers le porte-substrats sont coupés.

Cette configuration permet à l'enveloppe de protection 1 de protéger le canon à ions des salissures provenant des sources d'évaporation de matériaux 15a, 16.

Le cache canon 18 est positionné à l'intérieur de l'enveloppe de protection 1. La hauteur du cache canon 18 est inférieure à celle de la partie basse 5a du bord d'extrémité supérieure de l'enveloppe.

La paroi latérale 3 de l'enveloppe de protection 1 comprend une fente 19 allongée et configurée de façon à pouvoir être traversée par le cache canon 18 lorsqu'il se déplace entre les positions d'obturation a) et de dégagement b) de la sortie 13 du canon à ion. Le cache canon 18 est mobile dans un plan sensiblement perpendiculaire à l'axe longitudinal 20 de l'enveloppe de protection 1 plan horizontal.

La fente 19 est sensiblement perpendiculaire à l'axe longitudinal 20 de l'enveloppe de protection 1.

Le cache canon 18 est partiellement en dehors de l'enveloppe de protection 1 lorsqu'il est en position de dégagement b) de la sortie du canon à ion.

Le cache canon 18 est un disque plan en inox ayant une dimension comprise entre celle du canon à ions 2 et celle de l'enveloppe de protection 1. D'autres formes sont possibles également.

Par exemple, l'enveloppe de protection 1 peut être cylindrique et avoir un diamètre de 40 cm, et le canon à ions 2 qui présente un corps cylindrique, peut avoir un diamètre de 18 cm. Dans ce cas et de manière générale, le diamètre du cache canon 18 est compris entre celui du canon à ions 2 et celui de l'enveloppe de protection 1. Le diamètre du cache canon 18 est proche de celui du canon à ions 2, et au moins suffisant pour recouvrir la sortie 13 du canon à ion.

Le positionnement en hauteur du canon à ions dans l'enveloppe de protection est tel que l'écart entre la partie basse de l'enveloppe de protection et la partie haute du canon à ions peut être typiquement de 95 mm. La partie haute du canon est celle du filament 24 (cathode) du canon.

Le canon à ions peut présenter un axe aligné avec l'axe longitudinal 20 de l'enveloppe de protection ou former un angle avec celui-ci variant de 10° à 30°, préférentiellement de 20° à 30°.

La hauteur de la partie basse 5a de l'enveloppe de protection 1 est de 170 mm et la hauteur de la partie haute 5b de l'enveloppe de protection 1 est de 465 mm.

Pour un canon à ions de type « Mark Il », le canon à ions s'étend sur 75 mm, soit pratiquement la totalité de sa longueur dans l'enveloppe de protection, depuis la base 8 de l'enveloppe de protection 1.

Le cache canon 18 est positionné à une hauteur de 135 mm par rapport à la base 8 de l'enveloppe de protection 1.

Le cache canon 18 est actionné par des moyens de rotation comprenant un axe de rotation 21 sensiblement parallèle à l'axe longitudinal 20 de l'enveloppe de protection 1. Cet axe de rotation 21 est relié au cache canon 18 par un bras 22 sensiblement perpendiculaire à l'axe de rotation 21. L'axe de rotation 21 et le bras 22 sont disposés à l'intérieur de l'enveloppe de protection 1.

L'invention fournit un moyen permettant de limiter le temps de maintenance qui consiste en une enveloppe de protection pour canon à ions d'un dispositif de dépôt de matériaux par évaporation sous vide permettant de limiter la formation de salissures sur les parois latérales de l'enceinte de traitement et sur le canon à ions.

Il est ainsi possible de réaliser un plus grand nombre de cycles d'évaporations de matériaux entre deux opérations de nettoyage des parois latérales de l'enceinte de traitement (3 fois plus).

Ce qui suit est un exemple permettant de comparer les résultats obtenus avec un dispositif de dépôt de matériaux par évaporation sous vide de l'art antérieur, et un dispositif de dépôt de matériaux par évaporation sous vide muni d'une enveloppe de protection 1, selon l'invention.

### Exemple comparatif :

Pour cet exemple comparatif, on a utilisé le procédé de dépôt de l'empilement antireflets sur un substrat, correspondant à l'exemple 5 de la demande de brevet EP2122392.

Ce procédé de dépôt connu est mis en oeuvre avec un dispositif de dépôt de matériaux par évaporation sous vide muni d'une enveloppe de protection selon l'invention (dispositif 1), et un dispositif de dépôt de matériaux par évaporation sous vide sans cette enveloppe (dispositif 2).

L'empilement antireflets présente :
- une couche épaisse de TiO₂ qui subit lors de son dépôt une assistance ionique par des ions oxygène (canon à ions réglé à 3,5 A 140 V) ;
- une couche de ZrO₂, adjacente à la couche de TiO₂, cette couche de ZrO₂ étant également déposée par assistance ionique ;
- une couche d'ITO (Indium Tin Oxide) avec le même réglage du canon à ions (3,5 A 140 V).

Le dispositif de dépôt est une machine Satis 1200 DLF équipée d'un canon à électrons ESV 14 (8 kV) pour l'évaporation des oxydes, d'un creuset à effet joule pour le dépôt de la couche hydrophobe et d'un canon à ions Weeco Mark II™ (diamètre de 18 cm) pour les phases préliminaires de préparation de surface (IPC) du substrat et de la sous couche par des ions argons, pour le dépôt des couches sous assistance ionique (IAD).

On reporte dans le tableau suivant le nombre de tournées qu'il est possible d'effectuer sans disfonctionnement, selon que le procédé est effectué avec ou sans l'enveloppe de protection.

Le disfonctionnement correspond à une impossibilité de conserver des paramètres fixes lors de l'évaporation et/ou l'apparition de problèmes de reproductibilité.

Une tournée correspond à un cycle de dépôt d'un empilement en face convexe et un cycle de dépôt d'un empilement en face concave du substrat à traiter.

| | Nombre de tournées sans disfonctionnement du canon à ions |
|---|---|
| **Dispositif 1** (avec l'enveloppe de protection) | **96** tournées |
| **Dispositif 2** (sans l'enveloppe de protection) | **32** tournées |

## Revendications

1. Dispositif de dépôt de matériaux par évaporation sous vide comprenant une enceinte de traitement (10) délimitée au moins par des parois latérales (11), ladite enceinte de traitement (10) comportant un porte-substrats (12), un canon à ions (2) positionné à proximité d'une des parois latérales (11) de l'enceinte de traitement, et comprenant une sortie (13) apte à générer un faisceau d'ions (14) dirigé vers le porte-substrats (12), au moins une source d'évaporation de matériaux (15a, 16) et un cache-canon (18) mobile, ledit canon à ions (2) étant entouré par une enveloppe de protection (1) comprenant une paroi latérale (3) destinée à entourer ledit canon à ions (2), et une extrémité supérieure ouverte (4), ladite enveloppe de protection (1) présentant un axe longitudinal (20), une forme de tube tronqué à son extrémité supérieure ouverte (4) par une surface inclinée par rapport audit axe longitudinal (20), et comprenant une partie basse (5a) et une partie haute (5b), ladite enveloppe de protection (1) étant disposée de façon à ce que la partie haute (5b) de l'enveloppe de protection (1) soit positionnée le long d'une des parois latérales (11) de l'enceinte de traitement, et de façon à ce que l'extrémité supérieure ouverte (4) de l'enveloppe de protection (1) soit dirigée vers le porte-substrats (12),
le cache-canon (18) étant positionné à l'intérieur de l'enveloppe de protection (1), la hauteur du cache-canon (18) étant inférieure à celle de la partie basse (5a) de l'enveloppe de protection (1), la paroi latérale (3) de l'enveloppe de protection (1) comprenant une fente (19) allongée et configurée de façon à être traversée par le cache-canon (18) lorsqu'il se déplace entre les positions d'obturation a) et de dégagement b) de la sortie (13) du canon à ions (2), ledit cache-canon (18) étant mobile dans un plan sensiblement perpendiculaire à l'axe longitudinal (20) de l'enveloppe de protection (1).

2. Dispositif selon la revendication 1, **caractérisé en ce que** l'enveloppe présente une forme de tube tronqué à son extrémité supérieure ouverte (4) par une surface inclinée et incurvée dans une direction opposée à ladite extrémité supérieure ouverte.

3. Dispositif selon la revendication 1, **caractérisé en ce que** l'extrémité supérieure ouverte (4) de l'enveloppe de protection (1) présente une section inférieure (6a) sensiblement parallèle à un plan perpendiculaire à l'axe longitudinal (20) de l'enveloppe de protection (1), et une section supérieure (6b) inclinée par rapport à ladite section inférieure (6a), lesdites sections (6a, 6b) se rejoignant en formant un angle (7).

4. Dispositif selon l'une quelconque des revendications 1 à 3, **caractérisé en ce que** l'enveloppe de protection (1) comprend une base (8) munie d'un orifice (9) apte à être traversé par le canon à ions (2).

5. Dispositif selon l'une quelconque des revendications 1 à 4, **caractérisé en ce que** l'enveloppe de protection (1) est constituée d'inox amagnétique.

6. Dispositif de dépôt de matériaux par évaporation sous vide selon l'une quelconque des revendications 1 à 5, **caractérisé en ce que** la hauteur de la partie basse (5a) de l'enveloppe de protection (1) est à la fois supérieure à la hauteur du canon à ions (2) et adaptée pour que la partie basse (5a) de l'enveloppe de protection (1) n'empêche pas le faisceau d'ions (14) d'atteindre le porte-substrats (12).

7. Dispositif de dépôt de matériaux par évaporation sous vide selon l'une quelconque des revendications 1 à 6, **caractérisé en ce qu'**il comprend un canon à électrons (15b) apte à bombarder d'électrons la source de matériaux (15a) pour générer un faisceau de matériaux évaporés (17) dirigé vers le porte-substrats (12), la hauteur de la partie basse (5a) de l'enveloppe de protection (1) étant adaptée pour que la partie basse (5a) de l'enveloppe de protection (1) n'empêche ni le faisceau d'ions (14), ni le faisceau de matériaux évaporés (17) d'atteindre le porte substrats.

8. Dispositif de dépôt de matériaux par évaporation sous vide selon l'une quelconque des revendications précédentes, **caractérisé en ce que** le cache-canon (18) est un disque plan ayant une dimension proche de celle du canon à ions (2), et au moins suffisante pour recouvrir la sortie (13) du canon à ion.

9. Dispositif de dépôt de matériaux par évaporation sous vide selon l'une quelconque des revendications précédentes, **caractérisé en ce que** l'enveloppe de protection constitue un masque permettant de réduire l'angle solide du cône d'ions émis vers le porte-substrats et limitant l'émission d'ions vers les parois latérales (11) de l'enceinte de traitement.

10. Dispositif de dépôt de matériaux par évaporation sous vide selon l'une quelconque des revendications précédentes, **caractérisé en ce que** la fente (19) est sensiblement perpendiculaire à l'axe longitudinal (20) de l'enveloppe de protection (1).

11. Dispositif de dépôt de matériaux par évaporation sous vide selon l'une quelconque des revendications précédentes, **caractérisé en ce que** le cache-canon (18) est mobile en rotation entre la position d'obturation a) et la position de dégagement b) de la sortie (13) du canon à ions (2).

12. Procédé de dépôt de matériaux sur des substrats par évaporation sous vide, **caractérisé en ce que** les matériaux sont évaporés et déposés sur les substrats dans un dispositif de dépôt selon l'une quelconque des revendications 1 à 11.

## Patentansprüche

1. Vorrichtung zur Vakuumaufdampfung von Materialien, die einen mindestens von Seitenwänden (11) begrenzten Behandlungsraum (10), wobei der Behandlungsraum (10) einen Substratträger (12) aufweist, eine in der Nähe einer der Seitenwände (11) des Behandlungsraums positionierte Ionenkanone (2), die einen Ausgang (13) enthält, der einen zum Substratträger (12) gerichteten Ionenstrahl (14) erzeugen kann, mindestens eine Materialaufdampfungsquelle (15a, 16) und eine bewegliche Kanonenabdeckung (18) enthält, wobei die Ionenkanone (2) von einer Schutzhülle (1) umgeben ist, die eine Seitenwand (3), welche dazu bestimmt ist, die Ionenkanone (2) zu umgeben, und ein offenes oberes Ende (4) enthält, wobei die Schutzhülle (1) eine Längsachse (20), eine Form eines an seinem offenen oberen Ende (4) durch eine bezüglich der Längsachse (20) geneigte Fläche abgestumpften Rohrs hat, und einen unteren Teil (5a) und einen oberen Teil (5b) enthält, wobei die Schutzhülle (1) so angeordnet ist, dass der obere Teil (5b) der Schutzhülle (1) entlang einer der Seitenwände (11) des Behandlungsraums positioniert ist, und so angeordnet ist, dass das offene obere Ende (4) der Schutzhülle (1) zum Substratträger (12) gerichtet ist,
wobei die Kanonenabdeckung (18) im Inneren der Schutzhülle (1) positioniert ist, wobei die Höhe der Kanonenabdeckung (18) geringer als die des unteren Teils (5a) der Schutzhülle (1) ist, wobei die Seitenwand (3) der Schutzhülle (1) einen Längsschlitz (19) enthält, der konfiguriert ist, von der Kanonenabdeckung (18) durchquert zu werden, wenn sie sich zwischen den Stellungen des Verdeckens a) und des Freilegens b) des Ausgangs (13) der Ionenkanone (2) verschiebt, wobei die Kanonenabdeckung (18) in einer im Wesentlichen zur Längachse (20) der Schutzhülle (1) lotrechten Ebene beweglich ist.

2. Vorrichtung nach Anspruch 1, **dadurch gekennzeichnet, dass** die Hülle die Form eines an seinem offenen oberen Ende (4) durch eine geneigte Fläche abgestumpften und in einer Richtung entgegengesetzt zum offenen oberen Ende gekrümmten Rohrs hat.

3. Vorrichtung nach Anspruch 1, **dadurch gekennzeichnet, dass** das offene obere Ende (4) der Schutzhülle (1) einen unteren Abschnitt (6a) im Wesentlichen parallel zu einer Ebene lotrecht zur Längsachse (20) der Schutzhülle (1) und einen oberen Abschnitt (6b) aufweist, der bezüglich des unteren Abschnitts (6a) geneigt ist, wobei die Abschnitte (6a, 6b) sich unter Bildung eines Winkels (7) vereinen.

4. Vorrichtung nach einem der Ansprüche 1 bis 3, **dadurch gekennzeichnet, dass** die Schutzhülle (1) eine mit einer Öffnung (9), die von der Ionenkanone (2) durchquert werden kann, versehene Basis (8) enthält.

5. Vorrichtung nach einem der Ansprüche 1 bis 4, **dadurch gekennzeichnet, dass** die Schutzhülle (1) aus unmagnetischem rostfreiem Stahl besteht.

6. Vorrichtung zur Vakuumaufdampfung von Materialien nach einem der Ansprüche 1 bis 5, **dadurch gekennzeichnet, dass** die Höhe des unteren Teils (5a) der Schutzhülle (1) sowohl höher als die Höhe der Ionenkanone (2) als auch geeignet ist, damit der untere Teil (5a) der Schutzhülle (1) den Ionenstrahl (14) nicht daran hindert, den Substratträger (12) zu erreichen.

7. Vorrichtung zur Vakuumaufdampfung von Materialien nach einem der Ansprüche 1 bis 6, **dadurch gekennzeichnet, dass** sie eine Elektronenkanone (15b) enthält, die die Materialquelle (15a) mit Elektronen bombardieren kann, um einen Strahl von verdampften Materialien (17) zu erzeugen, der zum Substratträger (12) gerichtet ist, wobei die Höhe des unteren Teils (5a) der Schutzhülle (1) geeignet ist, damit der untere Teil (5a) der Schutzhülle (1) weder den Ionenstrahl (14) noch den Strahl von verdampften Materialien (17) daran hindert, den Substratträger zu erreichen.

8. Vorrichtung zur Vakuumaufdampfung von Materialien nach einem der vorhergehenden Ansprüche, **dadurch gekennzeichnet, dass** die Kanonenabdeckung (18) eine ebene Scheibe ist, die eine Abmessung nahe derjenigen der Ionenkanone (2) und mindestens ausreichend hat, um den Ausgang (13) der Ionenkanone zu bedecken.

9. Vorrichtung zur Vakuumaufdampfung von Materialien nach einem der vorhergehenden Ansprüche, **dadurch gekennzeichnet, dass** die Schutzhülle eine Maske bildet, die es ermöglicht, den Raumwinkel des zum Substratträger emittierten Ionenkegels zu verringern und die Ionenemission zu den Seitenwänden (11) des Behandlungsraums begrenzt.

10. Vorrichtung zur Vakuumaufdampfung von Materialien nach einem der vorhergehenden Ansprüche, **dadurch gekennzeichnet, dass** der Schlitz (19) im Wesentlichen lotrecht zur Längsachse (20) der Schutzhülle (1) ist.

11. Vorrichtung zur Vakuumaufdampfung von Materialien nach einem der vorhergehenden Ansprüche, **dadurch gekennzeichnet, dass** die Kanonenabdeckung (18) zwischen der Verdeckungsstellung a) und der Freilegestellung b) des Ausgangs (13) der Ionenkanone (2) drehbeweglich ist.

12. Verfahren zur Vakuumaufdampfung von Materialien auf Substrate, **dadurch gekennzeichnet, dass** die Materialien in einer Ablagerungsvorrichtung nach einem der Ansprüche 1 bis 11 auf die Substrate verdampft und abgelagert werden.

## Claims

1. A device for depositing materials through vacuum evaporation comprising a treating chamber (10) defined at least by side walls (11), said treating chamber (10) comprising a substrate holder (12), an ion gun (2) positioned close to one of the side walls (11) of the treating chamber, and comprising an outlet (13) that is able to generate an ion beam (14) directed towards the substrate holder (12), at least one material evaporation source (15a, 16) and a gun cover (18) that is movable, said ion gun (2) being surrounded by a protective enclosure (1) comprising one side wall (3) intended to surround said ion gun (2), and an open upper end (4), said protective enclosure (1) having a longitudinal axis (20), a truncated tube shape on its open upper end (4) resulting from an inclined surface relative to said longitudinal axis (20), and comprising a lower part (5a) and an upper part (5b), said protective enclosure (1) being arranged so that the upper part (5b) of the protective enclosure (1) is positioned along one of the side walls (11) of the treating chamber, and so that the open upper end (4) of the protective enclosure (1) is directed towards the substrate holder (12), the gun cover (18) being positioned inside the protective enclosure (1), the gun cover height (18) being lower than that of the lower part (5a) of the protective enclosure (1), the side wall (3) of the protective enclosure (1) comprising an elongated slot (19) designed in such a way that the gun cover (18) can pass through the same when switching from the close position a) to the open position b) of the ion gun outlet (13), said cover (18) being movable in a plane that is substantially perpendicular to the longitudinal axis (20) of the protective enclosure (1).

2. Device according to claim 1, **characterized in that** the enclosure (1) has a truncated tube shape on its open upper end (4) resulting from an inclined surface that is curved in the opposite direction relative to said open upper end.

3. Device according to claim 1, **characterized in that** the open upper end (4) of the protective enclosure (1) has a lower section (6a) substantially parallel to a plane that is perpendicular to the longitudinal axis (20) of the protective enclosure (1), and an upper section (6b) that is inclined relative to said lower section (6a), said sections (6a, 6b) joining together for forming an angle (7).

4. Device according to any one of claim 1 to 3, **characterized in that** the protective enclosure (1) comprises a base (8) provided with a hole (9) through which the ion gun can pass (2).

5. Device according to any one of claim 1 to 4, **characterized in that** the protective enclosure (1) is made of non magnetic stainless steel.

6. Device according to any one of claim 1 to 5, **characterized in that** the height of the lower part (5a) of the protective enclosure (1) is both higher than the height of the ion gun (2) and adapted so that the lower part (5a) of the protective enclosure (1) does not prevent the ion beam (14) from reaching the substrate holder (12).

7. Device according to any one of claim 1 to 6, **characterized in that** it comprises an electron gun (15b) that is able to bombard with electrons the material source (15a) to generate an evaporated material beam (17) directed towards the substrate holder (12), the height of the lower part (5a) of the protective enclosure (1) being adapted so that the lower part (5a) of the protective enclosure (1) does neither prevent the ion beam (14), nor the beam of evaporated materials (17) from reaching the substrate holder.

8. Device according to any one of claim 1 to 7, **characterized in that** the gun cover (18) is a flat disk having a size close to that of the ion gun (2), and at least sufficient for covering up the ion gun outlet (13).

9. Device according to any one of claim 1 to 8, **characterized in that** the protective enclosure acts as a mask for reducing the solid angle of the ion cone emitted towards the substrate holder and for limiting the ion emission towards the treating chamber side walls (11).

10. Device according to any one of claim 1 to 9, **characterized in that** the slot (19) is substantially perpendicular to the longitudinal axis (20) of the protective enclosure (1).

11. Device according to any one of claim 1 to 10, **characterized in that** the gun cover (18) is movable between the close position a) to the open position b) of the outlet (13) of the ion gun (2).

12. A method for depositing materials onto substrates through vacuum evaporation, **characterized in that** the materials are evaporated and deposited onto the substrates in a deposition device according to any of claims 5 to 11.
